(19) Europäisches Patentamt
European Patent Office
Office européen des brevets

(11) **EP 3 982 413 B1**

(12) **EUROPEAN PATENT SPECIFICATION**

(45) Date of publication and mention
of the grant of the patent:
**27.08.2025 Bulletin 2025/35**

(21) Application number: **20822207.5**

(22) Date of filing: **01.06.2020**

(51) International Patent Classification (IPC):
*G02F 1/1335* (2006.01)    *G02B 5/20* (2006.01)
*G02F 1/017* (2006.01)    *G02F 1/13357* (2006.01)

(52) Cooperative Patent Classification (CPC):
**G02B 5/201;** G02B 2207/113; G02F 1/133504;
G02F 1/133617; H10K 59/38

(86) International application number:
**PCT/KR2020/007093**

(87) International publication number:
**WO 2020/251201 (17.12.2020 Gazette 2020/51)**

(54) **COLOR CONVERSION PANEL**

FARBUMWANDLUNGSTAFEL

PANNEAU DE CONVERSION DE COULEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.06.2019 KR 20190068226**

(43) Date of publication of application:
**13.04.2022 Bulletin 2022/15**

(73) Proprietor: **Samsung SDI Co., Ltd.**
**Yongin-si, Gyeonggi-do 17084 (KR)**

(72) Inventors:
• **LEE, Seungeun**
**Suwon-si, Gyeonggi-do 16678 (KR)**

• **SHIN, Dongju**
**Suwon-si, Gyeonggi-do 16678 (KR)**
• **KIM, Ji Yoon**
**Suwon-si, Gyeonggi-do 16678 (KR)**
• **NAM, Seong Ryong**
**Suwon-si, Gyeonggi-do 16678 (KR)**

(74) Representative: **Michalski Hüttermann & Partner**
**Patentanwälte mbB**
**Kaistraße 16A**
**40221 Düsseldorf (DE)**

(56) References cited:
**JP-A- 2017 019 247     KR-A- 20040 047 949**
**KR-A- 20190 022 968     KR-A- 20190 027 006**
**KR-B1- 101 504 785**

Description

## CROSS-REFERENCE TO RELATED APPLICATION

This application claims priority to and the benefit of Korean Patent Application No. 10-2019-0068226 filed in the Korean Intellectual Property Office on June 10, 2019.

## BACKGROUND OF THE INVENTION

### (a) Field of the Invention

This disclosure relates to a color conversion panel.

### (b) Description of the Related Art

Low refractive index materials may be used for various devices dealing with light. When using characteristics of a low refractive index, low reflectance effect may be exhibited. The low refractive index materials may be used for a layer that decreases light loss on a low reflection layer of a lens outside of a photosensor, on an anti-reflection coating (AR) of an outermost of a display or a solar cell, or inside the device where light moves, to increase efficiency. In addition, as the refractive index of the coating layer is lowered, a thickness of the coating layer may be decreased, and thus a margin of the coating film may become wider and efficiency according to device purposes may be increased.

Particularly, as a display has been recently developed, various display devices using displays are diversified. There are needs for luminous efficiency of photoluminescence materials in OLED or display devices including quantum dots of the display devices.

By existing technologies, a baking process is required at a temperature of 350 °C or higher and at least 300 °C or higher when using a thermosetting low refractive index material. Alternatively, it is necessary to use vapor deposition such as CVD (Chemical Vapor Deposition) method, but it is difficult to obtain low-refractive properties as described above. Alternatively, expensive hollow particles (hollow silica) has been used, but these may be scattered in processes such as etch and patterning, making subsequent processing difficult.

Color conversion panels or materials for those panels are inter alia disclosed in the EP 3 451 052, EP 2 180 354 and EP 3 447 572.

## SUMMARY OF THE INVENTION

[Technical Problem]

The invention provides a color conversion panel having increased luminous efficiency according to the features defined in appended claim 1.

The technical object to be solved by the present invention is not limited to those mentioned above, and another technical objects which are not mentioned will be clearly understood by a person having an ordinary skill in the art to which the present invention pertains from the following descriptions.

[Technical Solution]

(1) The invention provides a color conversion panel including a substrate, a color conversion layer disposed on the substrate and including a color conversion member, a low refractive layer disposed between the substrate and the color conversion layer, disposed on the color conversion layer, or disposed between the substrate and the color conversion layer and disposed on the color conversion layer, and a planarization layer covering the low refractive layer and the color conversion layer, wherein the color conversion member includes quantum dots and the low refractive layer includes a polymer matrix and hollow particles dispersed in the polymer matrix.

(2) The low refractive layer may be disposed on the color conversion layer.

(3) The low refractive layer has a refractive index of less than 1.32 for light having a wavelength of 500 nm to 550 nm.

(4) The low refractive layer may have a light transmittance of greater than or equal to 90% for light having a wavelength of 400 nm.

(5) The polymer matrix may include a silicone-based polymer or an acrylic-based polymer.

(6) The polymer matrix may include a silicone-based polymer formed by a hydrolysis-condensation reaction of a compound represented by Chemical Formula 1 and/or a compound represented by Chemical Formula 2.

[Chemical Formula 1] $(R^1)_a(R^2)_b(R^3)_c\text{-Si-}(OR^4)_{4-a-b-c}$

In Chemical Formula 1,

$R^1$ to $R^3$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, R(C=O)- (wherein, R is a substituted or unsubstituted C1 to C30 alkyl group, a substituted or unsubstituted C3 to C30 cycloalkyl group, or a substituted or unsubstituted C6 to C30 aryl group), an epoxy group, a (meth)acrylate group, a (meth)acryloyloxy group, or a combination thereof,
$R^4$ is hydrogen, or a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, or a combination thereof, and

$$0 \leq a+b+c < 4;$$

[Chemical Formula 2] $(R^7O)_{3-d-e}(R^5)_d(R^6)_e\text{-Si-}Y^1\text{-Si-}(R^B)_f(R^9)_g(OR^{10})_{3-f-g}$

wherein, in Chemical Formula 2,

$R^5$, $R^6$, $R^8$, and $R^9$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, R(C=O)-(wherein R is a substituted or unsubstituted C1 to C30 alkyl group, a substituted or unsubstituted C3 to C30 cycloalkyl group, or a substituted or unsubstituted C6 to C30 aryl group), an epoxy group, a (meth)acrylate group, a C1 to C30 alkyl group substituted with a (meth)acrylate group, a (meth)acryloyloxy group, or a combination thereof,
$R^7$ and $R^{10}$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, or a combination thereof,
$Y^1$ is a substituted or unsubstituted C1 to C30 alkylene group, a substituted or unsubstituted C3 to C30 cycloalkylene group, a substituted or unsubstituted C6 to C30 arylene group, or a combination thereof,

$$0 \leq d+e < 3,$$

and

$$0 \leq f+g < 3.$$

(7) A weight average molecular weight (Mw) of the silicone-based polymer may be 1,000 to 100,000 g/mol in terms of a polystyrene standard sample.
(8) The polymer matrix may be a carbosilane-siloxane copolymer prepared by a hydrolysis-condensation reaction of the compound represented by Chemical Formula 1 and the compound represented by Chemical Formula 2.
(9) The carbosilane-siloxane copolymer may be prepared by a hydrolysis-condensation reaction by including less than or equal to 20% of the compound represented by Chemical Formula 2, based on a total mass of the compound represented by Chemical Formula 1 and the compound represented by Chemical Formula 2.
(10) The hollow particles may be particulates of a hollow metal oxide including titanium oxide, silicon oxide, barium oxide, zinc oxide, zirconium oxide, or a combination thereof.
(11) The hollow metal oxide particulates may include $TiO_2$, $SiO_2$, $BaTiO_3$, $Ba_2TiO_4$, ZnO, $ZrO_2$, or a combination thereof.
(12) An average diameter (D50) of the hollow particles may be 10 nm to 150 nm.

(13) A porosity of the hollow particles may be 40% to 90%.

(14) The hollow particles may be included in an amount of less than or equal to 80 mass% based on a total mass of the low refractive layer.

(15) The color conversion member may further include a binder resin in which the quantum dots are dispersed.

(16) The binder resin in the color conversion member may include an acrylic-based binder resin, cardo-based binder resin, or a combination thereof.

(17) The quantum dots may have a maximum fluorescence emission at a wavelength from 500 nm to 680 nm.

(18) The planarization layer may include a polymer matrix that is the same as or different from the polymer matrix included in the low refractive layer.

(19) The color conversion panel may further include at least one of a first capping layer covering the planarization layer and a second capping layer disposed between the low refractive layer and the color conversion layer.

[Advantageous Effects]

According to the present disclosure, a color conversion panel capable of improving luminous efficiency may be provided.

## BRIEF DESCRIPTION OF THE DRAWINGS

FIG. 1 is a schematic top plan view of a color conversion panel according to an embodiment.

FIG. 2 is a schematic cross-sectional view showing a cross-section taken along the II-II line of FIG. 1.

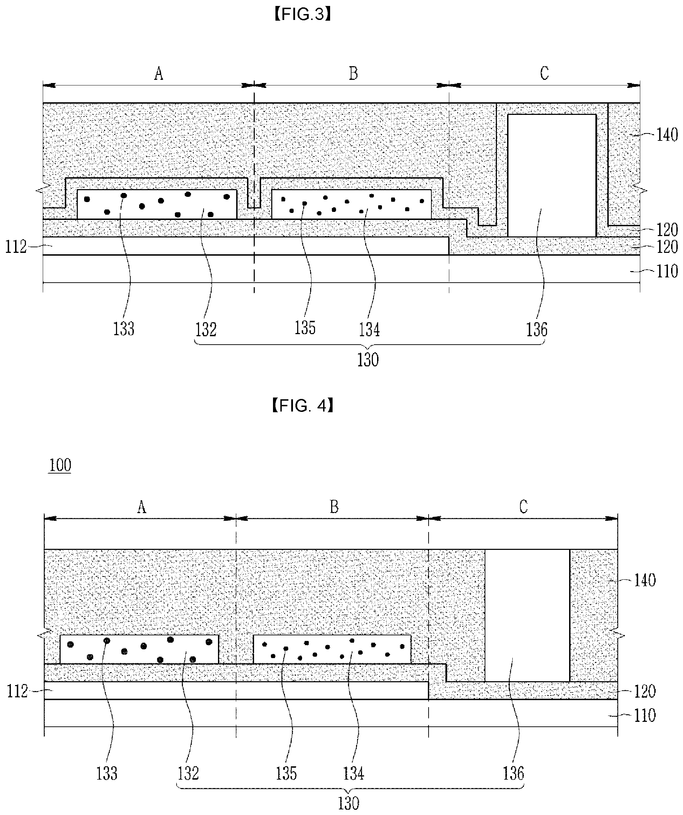

FIG. 3 is a cross-sectional view according to an exemplary variation of FIG. 2.

FIG. 4 is a cross-sectional view according to an exemplary variation of FIG. 2.

FIG. 5 is a cross-sectional view according to an exemplary variation of FIG. 2.

<Description of Symbols>

| | |
|---|---|
| 100: color conversion panel | 110: substrate |
| 112: protective layer | 120: low refractive layer |
| 130: color conversion layer | 132: first color conversion member |
| 133: first quantum dot member | 134: second color conversion |
| 135: second quantum dot | 136: transmitting member |
| 140: planarization layer | 150: first capping layer |
| 160: second capping layer | A: first region |
| B: second region | C: third region |

## DETAILED DESCRIPTION OF THE EMBODIMENTS

Hereinafter, the example embodiments of the present invention will be described in detail, referring to the accompanying drawings. However, in the description of the present disclosure, descriptions for already known functions or components will be omitted for clarifying the gist of the present disclosure.

In order to clearly describe the present disclosure, parts which are not related to the description are omitted, and the same reference numeral refers to the same or like components, throughout the specification. In addition, since the size and the thickness of each component shown in the drawing are optionally represented for convenience of the description, the present disclosure is not limited to the illustration.

In the drawings, the thickness of layers, films, panels, regions, etc., are exaggerated for clarity. In the drawings, the thickness of a part of layers or regions, etc., is exaggerated for clarity. It will be understood that when an element such as a layer, film, region, or substrate is referred to as being "on" another element, it can be directly on the other element or intervening elements may also be present.

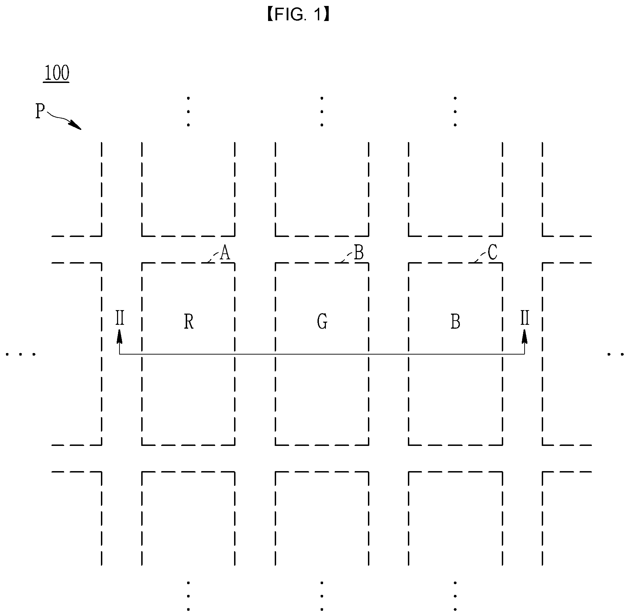

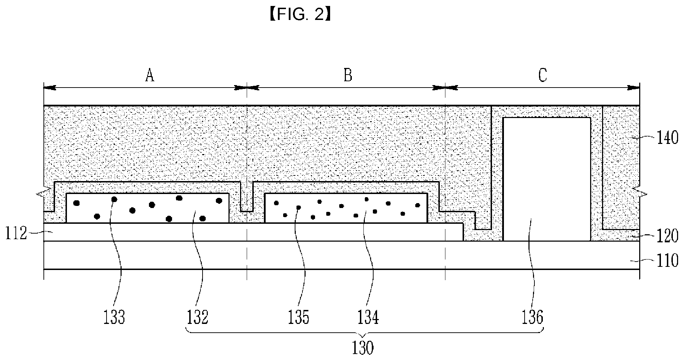

FIG. 1 is a schematic top plan view of a color conversion panel 100 according to an embodiment and FIG. 2 is a schematic cross-sectional view showing a cross-section taken along the II-II line of FIG. 1.

Referring to FIG. 2, a color conversion panel 100 according to an example embodiment includes a substrate 110, a low refractive layer 120, a color conversion layer 130, and a planarization layer 140, wherein the color conversion layer 130 may include color conversion layers that emit at least two light having different wavelengths such as a first color conversion layer 132 that emits light having a first wavelength and a second color conversion layer 134 that emits light having a second wavelength.

The substrate 110 is made of a transparent and electrically insulative material and a protective layer 112 may be further included at positions corresponding to the first color conversion layer 132 and the second color conversion layer 134. The protective layer 112 is formed on one surface of the substrate 110 and makes patterning of the color conversion layer be performed smoothly and protects the color conversion member inside the color conversion layer when the color conversion layer 130 is formed on the substrate 110.

The low refractive layer 120 may cover a portion of the substrate 110 and the protective layer 112 on one surface of the substrate 110, for example, one surface of the substrate 110 on which the protective layer 112 is formed, or may be formed on the color conversion layer 130 to cover the color conversion layer 130, a portion of the substrate 110, and the protective layer 112. The low refractive layer 120 has a relatively low refractive index of less than 1.32, for example, less than or equal to 1.31, less than or equal to 1.30, less than or equal to 1.29, less than or equal to 1.28, less than or equal to 1.27, less than or equal to 1.26, less than or equal to 1.25, less than or equal to 1.24, less than or equal to 1.23, less than or equal to 1.22, less than or equal to 1.21, or less than or equal to 1.20, for light having a wavelength of 500 nm to 550 nm. When the low refractive layer 120 is formed on or under the color conversion layer 130, or both on and under the color conversion layer 130, light emitted from the color conversion layer 130 may be prevented from being reflected toward the substrate 110. That is, as light passes through the low refractive layer 120, it is reflected or refracted due to a difference in refractive index and moves to the color conversion layer 130 again, so that the lost light is reused. Accordingly, the luminous efficiency of the color conversion panel 100 according to an embodiment in which the low refractive layer 120 is formed on or under the color conversion layer 130 or both on and under the color conversion layer 130 may be further improved. The refractive index in the present specification refers to an absolute refractive index indicating a ratio of speeds of light in vacuum and a medium.

In addition, the low refractive layer 120 may have light transmittance of greater than or equal to 90%, for example, greater than or equal to 91%, greater than or equal to 92%, greater than or equal to 93%, greater than or equal to 94%, greater than or equal to 95%, greater than or equal to 96%, greater than or equal to 97%, greater than or equal to 98%, or greater than or equal to 99%, for light having a wavelength of 400 nm, but is not limited thereto. When the light transmittance of the low refractive layer 120 for the light having the wavelength of 400 nm satisfies the above ranges, optical properties of the low refractive layer 120 may be further improved.

The low refractive layer 120 according to an embodiment includes a polymer matrix and hollow particles dispersed in the polymer matrix. The low refractive layer 120 may be formed by coating a composition for forming a low refractive layer including a polymer and hollow particles on the substrate 110 and forming a polymer matrix and curing the same. Each component of the composition for forming the low refractive layer will be described in detail below.

As described above, the low refractive layer 120 is formed on and/or under the color conversion layer 130. The color conversion panel 100 according to an example embodiment in FIG. 1 includes a first color conversion layer 132 that emits light having a first wavelength and a second color conversion layer 134 that emits light having a second wavelength. For example, the first color conversion layer 132 may emit red light and the second color conversion layer 134 may emit green light, but they are not limited thereto. In addition, the color conversion panel 100 may emit blue light or may further include a third region (C) emitting white light.

The first color conversion layer 132 and the second color conversion layer 134 respectively include a first color conversion member 133 emitting light having a first wavelength and a second color conversion member 135 emitting light having a second wavelength, and each of the first color conversion member 133 and the second color conversion member 135 may include quantum dots that convert a wavelength of incident light into other wavelengths. The color conversion member and the quantum dot included in the color conversion layer 130 will be described later.

Meanwhile, referring to FIG. 1, the color conversion layer 130 may further include a transmitting member 136 disposed corresponding to the third region (C). The transmitting member 136 may emit light received from a light source as itself without separate color conversion. For this, for example, the transmitting member 136 may be formed at the same height as the color conversion layer 130. However, the transmitting member 136 is not limited thereto, and may also include quantum dots in order to emit light of which a wavelength is converted into a certain wavelength like the first color conversion layer 132 and the second color conversion layer 134.

Hereinafter, each component of the composition for forming the low refractive layer for forming the low refractive layer 120 according to an embodiment is described in detail.

## Silicone-based Polymer

The low refractive layer 120 may be disposed between the substrate 110 and the color conversion layer 130, may be disposed on the color conversion layer 130, or may be disposed at both of between the substrate 110 and the color conversion layer 130 and on the color conversion layer 130, and the low refractive layer 120 may include a polymer matrix and hollow particles dispersed in the polymer matrix. The polymer matrix may include a polymer having low-refractive properties, and as an example of such a polymer, a silicone-based polymer, an acrylic-based polymer, an epoxy-based polymer, etc. may be used. In an embodiment, the polymer may be a silicone-based polymer.

By including the polymer having the low-refractive properties, the low-refractive layer may improve luminous efficiency of the color conversion panel by recycling the amount of light lost when light moves between the layers of the panel.

In particular, since it is difficult to increase luminous efficiency of a green QD light emitting body, it is possible to help the luminous efficiency of the green QD light emitting body by introducing a low-refractive coating film as the upper and lower layers of the green QD.

In an example embodiment, the polymer matrix may include the silicone-based polymer and the silicone-based polymer may be formed by a hydrolysis-condensation reaction of a compound represented by Chemical Formula 1 and/or a compound represented by Chemical Formula 2.

[Chemical Formula 1] $(R^1)_a(R^2)_b(R^3)_c\text{-Si-}(OR^4)_{4-a-b-c}$

In Chemical Formula 1,

$R^1$ to $R^3$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, R(C=O)- (wherein, R is a substituted or unsubstituted C1 to C30 alkyl group, a substituted or unsubstituted C3 to C30 cycloalkyl group, or a substituted or unsubstituted C6 to C30 aryl group), an epoxy group, a (meth)acrylate group, a (meth)acryloyloxy group, or a combination thereof,

$R^4$ is hydrogen, or a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, or a combination thereof, and

$$0 \leq a+b+c < 4;$$

[Chemical Formula 2] $(R^7O)_{3-d-e}(R^5)_d(R^6)_e\text{-Si-}Y^1\text{-Si-}(R^8)_f(R^9)_g(OR^{10})_{3-f-g}$

wherein, in Chemical Formula 2,

$R^5$, $R^6$, $R^8$, and $R^9$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, R(C=O)-(wherein R is a substituted or unsubstituted C1 to C30 alkyl group, a substituted or unsubstituted C3 to C30 cycloalkyl group, or a substituted or unsubstituted C6 to C30 aryl group), an epoxy group, a (meth)acrylate group, a C1 to C30 alkyl group substituted with a (meth)acrylate group, a (meth)acryloyloxy group, or a combination thereof,

$R^7$ and $R^{10}$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, or a combination thereof,

$Y^1$ is a substituted or unsubstituted C1 to C30 alkylene group, a substituted or unsubstituted C3 to C30 cycloalkylene group, a substituted or unsubstituted C6 to C30 arylene group, or a combination thereof,

$$0 \leq d+e < 3,$$

and

$$0 \leq f+g < 3.$$

$R^1$ to $R^3$ of Chemical Formula 1 may independently be hydrogen, a substituted or unsubstituted C1 to C10 alkyl group, a substituted or unsubstituted C2 to C10 alkenyl group, a substituted or unsubstituted C6 to C10 aryl group, an epoxy group, a (meth)acrylate group, a (meth)acryloyloxy group, or a combination thereof, and $R^4$ may be hydrogen, a substituted or unsubstituted C1 to C10 alkyl group, a substituted or unsubstituted C2 to C4 acyl group, or a substituted or unsubstituted C6 to C10 aryl group.

$R^5$, $R^6$, $R^8$, and $R^9$ of Chemical Formula 2 may independently be hydrogen, a substituted or unsubstituted C1 to C10 alkyl group, a substituted or unsubstituted C2 to C10 alkenyl group, a substituted or unsubstituted C6 to C10 aryl group, an epoxy group, a (meth)acrylate group, a (meth)acryloyloxy group, or a combination thereof and $R^7$ and $R^{10}$ may independently be hydrogen, a substituted or unsubstituted C1 to C10 alkyl group, a substituted or unsubstituted C2 to C4 acyl group, or a substituted or unsubstituted C6 to C10 aryl group.

$Y^1$ of Chemical Formula 2 may be a substituted or unsubstituted C1 to C10 alkylene group, a substituted or unsubstituted C3 to C6 cycloalkylene group, a substituted or unsubstituted C6 to C10 arylene group, or a combination thereof.

A weight average molecular weight (Mw) of the silicone-based polymer in terms of a polystyrene standard sample may be 1,000 to 100,000, for example, 1,000 to 90,000, 1,000 to 80,000, 1,000 to 70,000, 1,000 to 60,000, 1,000 to 50,000 1,000 to 40,000, 1,000 to 30,000, 1,000 to 20,000, 1,000 to 10,000, 2,000 to 100,000, 3,000 to 100,000, 4,000 to 100,000, 5,000 to 100,000, 6,000 to 100,000, 7,000 to 100,000, 8,000 to 100,000, 9,000 to 100,000, or 10,000 to 100,000, but is not limited thereto.

In an example embodiment, the polymer matrix may include a carbosilane-siloxane copolymer formed by a hydrolysis-condensation reaction of the compound represented by Chemical Formula 1 and the compound represented by Chemical Formula 2.

The carbosilane-siloxane copolymer may be formed by a hydrolysis-condensation reaction by including less than or equal to 20%, less than or equal to 18%, less than or equal to 16%, less than or equal to 15%, less than or equal to 14%, less than or equal to 12%, or less than or equal to 10% of the compound represented by Chemical Formula 2, based on a total mass of the compound represented by the above Chemical Formula 1 and the compound represented by Chemical Formula 2, but is not limited thereto.

The carbosilane-siloxane copolymer prepared by the hydrolysis condensation reaction by including the compound represented by Chemical Formula 2 within the above ranges may form a polymer matrix having high surface hardness, not having crack at high temperatures, and having a high transmittance and a low refractive index.

## Hollow Particles

The low refractive layer may further lower a refractive index of the low refractive layer by further including hollow particles together with the polymer matrix having the low refractive properties described above. Specifically, the low refractive layer may include air inside the low refractive layer by including the hollow particles, and the refractive index of the low refractive layer may be further lowered due to the low refractive index of the air. As the refractive index of the low refractive layer is further lowered, luminous efficiency of the color conversion layer 130 disposed on and/or under the low refractive layer 120 may be further increased.

The hollow particles may be particulates of hollow metal oxides including titanium oxide, silicon oxide, barium oxide, zinc oxide, zirconium oxide, or a combination thereof, but are not limited thereto.

As an example, the hollow metal oxide particulates may include $TiO_2$, $SiO_2$, $BaTiO_3$, $Ba_2TiO_4$, ZnO, $ZrO_2$, or a combination thereof, and in an embodiment, the hollow metal oxide particulates may be hollow silica ($SiO_2$) but are not limited thereto.

An average diameter ($D_{50}$) of the hollow particles may be 10 nm to 150 nm, for example, 10 nm to 130 nm, 10 nm to 110 nm, 20 nm to 110 nm, 40 nm to 110 nm, or 60 nm to 110 nm, but is not limited thereto. When the average diameter size of the hollow particles satisfies the above ranges, the hollow particles may be well dispersed in the polymer matrix in the low refractive layer, and the refractive index of the low refractive layer may be effectively reduced.

A porosity of the hollow particles may be 40% to 90%, for example, 40% to 80%, 40% to 70%, 40% to 60%, 40% to 50%, 50% to 90%, 60% to 90%, 70% to 90%, 80% to 90%, or 50% to 70%, but is not limited thereto. When the porosity of the hollow particles exceeds the above range, sizes of the inner spaces of the hollow particles becomes large and thickness of the outer periphery thereof becomes small, and thus durability of the hollow particles may be decreased, while when the porosity of the hollow particles is less than the above range, an effect of reducing the refractive index of the low refractive layer may be negligible.

The hollow particles may be included in an amount of less than or equal to 80 mass%, less than or equal to 75 mass%, less than or equal to 70 mass%, less than or equal to 65 mass%, less than or equal to 60 mass%, less than or equal to 55 mass%, less than or equal to 50 mass%, less than or equal to 45 mass%, less than or equal to 40 mass%, less than or equal to 35 mass%, less than or equal to 30 mass%, or less than or equal to 25 mass%, based on a total mass of the low refractive layer, but are not limited thereto. When the hollow particles are included in the amount ranges, the refractive index of the low refractive layer may be lowered, and accordingly, the luminous efficiency of the color conversion panel may be increased.

### Solvent

The low refractive layer 120 may be prepared by dispersing the polymer and the hollow particles in a solvent capable of dispersing the silicone-based polymer and the hollow particles, and coating the composition for forming the low refractive layer 120 onto the substrate 110 to cure it. Therefore, the composition for forming the low refractive layer may further include a solvent, and the solvent may be any solvent usable at a process temperature of greater than or equal to 200 °C. For example, the solvent may be an alcohol-type solvent, for example, butanol or isopropanol, a ketone-type solvent, for example, PMEA or DIBK, and may be one or more of any solvent that may be used at the process temperature as known solvent in this art beside these solvents.

When a solvent is used in a mixture of two or more, a mixture of propylene glycol methyl ether acetate (PGMEA), gamma-butyrolactone (GBL), and other types of solvent, which may be used at a process temperature of 100 °C to 230 °C may be used.

In an example embodiment, the solvent may be included in an amount of 300 to 2,000 parts by weight, for example, 500 to 2,000 parts by weight, 800 to 2,000 parts by weight, 1,000 to 2,000 parts by weight, 1,300 to 2,000 parts by weight, or 1,500 to 2,000 parts by weight, based on the sum amount, 100 parts by weight of the silicone-based polymer, for example, carbosilane-siloxane copolymer and hollow particles, but is not limited thereto.

### Curing Catalyst

The composition for forming the low refractive layer may further include a curing catalyst for promoting curing of an unreacted silanol group or an epoxy group at the siloxane resin terminal end of the silicone-based polymer, for example, the carbosilane-siloxane copolymer, and such a curing catalyst may be a thermosetting catalyst or a photocuring catalyst. Also, depending on the polymer used, this curing catalyst may not be included. In an embodiment, an example of a curing catalyst for curing the silicone-based polymer may have an ammonium salt form such as tetrabutylammonium acetate (TBAA).

When the curing catalyst is used, the catalyst may be included in an amount of 0.1 to 1 part by weight, for example, 0.3 to 1 part by weight, 0.5 to 1 part by weight, 0.7 to 1 part by weight, or 0.8 to 1 part by weight based on 100 parts by weight of the silicone-based polymer, but is not limited thereto.

### Surface Modifying Additives

The composition for forming the low refractive layer may further include various additives known in the art, and may further include a surface-modifying additive as an additive. When the composition for forming the low refractive layer includes the surface-modifying additive, it is possible to implement an effect of improving coating properties and preventing defects when coating the composition for forming the low refractive layer.

As the surface-modifying additive, a surfactant, for example, a fluorinebased surfactant may be further included, but is not limited thereto.

These additives may be included in an amount of less than or equal to about 5 parts by weight, for example, 1 to 5 parts by weight, 2 to 5 parts by weight, or 3 to 5 parts by weight based on 100 parts by weight of the silicone-based polymer, and are not limited thereto.

By coating the composition for forming the low refractive layer including the components as described above on a substrate, and then drying, and curing the same, the low refractive layer including the silicone-based polymer and hollow particles may be formed.

The composition for forming the low refractive layer may be coated on the substrate using any method of known various methods in this art, and may be for example, a spin coating, a slit and spin coating, a slit coating, a roll coating method, or a die coating, but is not limited thereto. In an example embodiment, the composition for forming the low refractive layer may be spincoated on the substrate.

The composition for forming the low refractive layer including the silicone-based polymer and hollow particles which is coated on the substrate may be dried or cured by the drying and curing processes to form a low refractive layer. The drying or curing temperature may be a temperature of greater than or equal to 150 °C and less than or equal to 300 °C, greater than or equal to 150 °C and less than or equal to 280 °C, greater than or equal to 150 °C and less than or equal to 270 °C, greater than or equal to 150 °C and less than or equal to 250 °C, greater than or equal to 170 °C and less than or equal to 250 °C, or greater than or equal to 180 °C and less than or equal to 240 °C.

The low refractive layer 120 manufactured according to the method may have a thickness of 100 nm to 5.0 μm.

The silicone-based polymer included in the composition for forming the low refractive layer may include a hydrolysis-condensation reaction product of the compound represented by Chemical Formula 1 and/or the compound represented by Chemical Formula 2, and the composition for forming the low refractive layer may further include the solvent, the curing catalyst, and the surface-modifying additive.

Meanwhile, the low refractive layer 120 may have a transmittance of greater than or equal to 60%, for example greater than or equal to 70%, greater than or equal to 80%, greater than or equal to 90%, greater than or equal to 95% in a remaining visible light wavelength region including a wavelength of 400 nm except a certain wavelength region.

In addition, an average reflectance (SCE value) in a visible light range of an entire wavelength region of 400 nm to 750 nm may be less than or equal to 10%, less than or equal to 7%, less than or equal to 5%, or less than or equal to 3%. Accordingly, the color conversion panel 100 according to an embodiment may have high light transmittance even at a low wavelength region, and may maintain a low reflectance through an entire wavelength region of a visible light to further improve optical properties.

As described above, the color conversion layer 130 may be formed on a substrate, and the low refractive layer 120 may be disposed between the substrate and the color conversion layer, disposed on the color conversion layer, or disposed at both between the color conversion layer and the substrate and on the color conversion layer. The color conversion layer 130 includes the color conversion members 133 and 135 including quantum dots that absorb light each having certain wavelength and emit light having other wavelengths. Such color conversion members may be formed by applying a composition for forming the color conversion layer including quantum dots, on a substrate or a protective layer formed on the substrate, or when the low refractive layer 120 is first formed, on the low refractive layer 120. The composition for forming the color conversion layer may include quantum dots, a binder resin, a photopolymerizable monomer, a photopolymerization initiator, a solvent, and other additives.

In an embodiment, the color conversion layer 130 is formed by coating a composition for forming a color conversion layer including the color conversion members 133 and 135 including quantum dots, on the low refractive layer 120 formed on the substrate 110, and by going through a patterning process, and is alternatively formed by coating it on a substrate 110 or a protective layer formed on the substrate 110 and then going through a patterning process. The patterning process may include, for example coating the composition for forming the color conversion layer on the substrate 110 using a method of a spin or slit coating, a roll coating method, a screen-printing method, an applicator method, and the like, drying the same to form a film, exposing the film to form a pattern having shapes corresponding to the first color conversion layer 132 and the second color conversion layer 134 using a mask, developing the same to remove unnecessary parts, and heat resistance, and a post process to reheat the same in order to obtain a pattern having improved light resistance, close contacting property, crack resistance, chemical resistance, high strength, storage stability, and the like, or to irradiate an actinic ray, but is not limited thereto.

The first and second color conversion layers 132 and 134 may further include a light scatterer (not shown) in addition to the color conversion members 133 and 135 including the quantum dots. The light scatterer may be dispersed in the color conversion layer 130 along with the quantum dots. The light scatterer may induce incident light to reach the quantum dots or a radiation direction so that a radiated light emitted from the quantum dots may be emitted outside from the color conversion layer 130. Thereby, deterioration of the light efficiency of the color conversion layer 130 may be minimized. On the other hand, the transmitting member 136 may also include a light scatterer.

The planarization layer 140 is formed on the low refractive layer 120 and the color conversion layer 130. The planarization layer 140 covers the low refractive layer 120 and the color conversion layer 130 to protect them and planarizes the surface of the color conversion panel 100. The planarization layer 140 may be made of a transparent and electrically insulative material so that light may be transmitted. Herein, the planarization layer 140 according to the present embodiment may consist of the same or different polymer matrix as the low refractive layer 120.

For example, the planarization layer 140 is made of a low refractive index material including the carbosilane-siloxane copolymer like the low refractive layer 120 and thereby luminous efficiency of the color conversion panel 100 may be further improved. In addition, when incident light of the low refractive layer 120 enters the planarization layer 140, reflection or scattering may be minimized, and thereby optical loss at the interface may be minimized to provide the color conversion panel 100 having improved light efficiency.

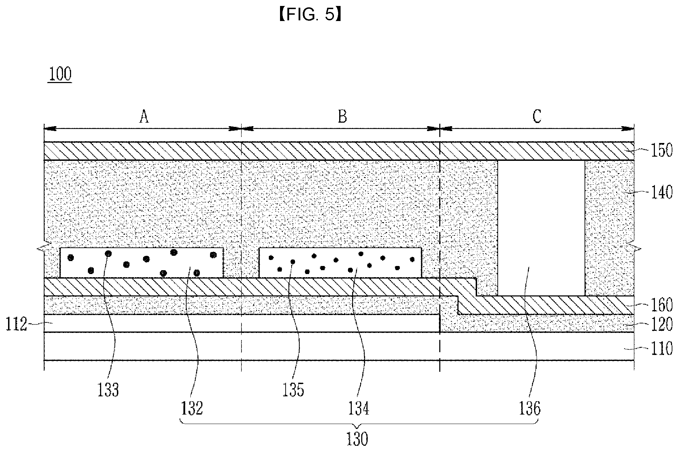

FIG. 5 is a cross-sectional view of an exemplary variation of FIG. 2. Referring to FIG. 5, the color conversion panel 100 according to an exemplary variation may further include a first capping layer 150 and a second capping layer 160. In FIG. 5, exemplary variation including the first capping layer 150 and the second capping layer 160 is shown but one of them may be omitted.

The first capping layer 150 may be formed on the planarization layer 140 to cover the planarization layer 140. Therefore, it may be formed after forming the planarization layer 140. The first capping layer 150 may be formed on the whole surface of the substrate 110.

The second capping layer 160 may be formed between the low refractive layer 120 and the color conversion layer 130 and may be formed on the whole surface of the substrate 110, like the first capping layer 150. Therefore, the second capping layer 160 may be formed between a forming process of the low refractive layer 120 and a forming process of the color conversion layer 130.

The first capping layer 150 and the second capping layer 160 may also be made of a material having a low refractive index, for example $SiN_x$, like the low refractive layer 120. The first capping layer 150 forming an interface with the planarization layer 140 and the second capping layer 160 disposed between the low refractive layer 120 and the planarization layer 140 or between the low refractive layer 120 and the color conversion layer 130 and forming interfaces with them may also be made of a material having a low refractive index, and thereby reflection or scattering of incident light to the first capping layer 150 and the second capping layer 160 may be minimized and thus optical loss at the interfaces may be minimized to provide the color conversion panel 100 having improved light efficiency.

That is, by minimizing the case of being reflected or scattered, it is possible to provide a color conversion panel 100 with improved light efficiency by minimizing optical loss at the interface.

The color conversion panel 100 including the first capping layer 150 and the second capping layer 160 may exhibit increase effects of luminous efficiency of 150% or greater compared with a color conversion panel not including the low refractive layer 120, the first capping layer 150, and the second capping layer 160.

The color conversion panel 100 according to an embodiment of the present invention and a method of manufacturing the same are explained. Accordingly, in the color conversion panel 100 including quantum dots, it is possible to provide a color conversion panel 100 in which luminous efficiency is improved by quantum dots.

Hereinafter, the present invention is illustrated in more detail with reference to examples. These examples, however, are not in any sense to be interpreted as limiting the scope of the invention.

## Synthesis Example: Preparation of Silicone-based Polymer

### Synthesis Example 1

39.39 g (0.51 mol) of methyltrimethoxy silane (MTMS), 39.66 g (0.415 mol) of tetraethyl orthosilicate (TEOS), 15.08 g (0.075 mol) of 1,2-bistriethoxysilylethane, and 192.40 g of propylene glycol methyl ether acetate (PGMEA) were put in a 500 ml 3-neck flask, and a hydrochloric acid aqueous solution prepared by dissolving 0.093 g (286 ppm) of hydrochloric acid in 33.10 g of water, while stirred at room temperature, was added thereto over 10 minutes. Subsequently, the flask was dipped in a 60 °C oil bath and stirred for 180 minutes and then, reacted by using a vacuum pump and a dean-stark for 180 minutes, and 67.3 g of side products such as methanol, ethanol, a hydrochloric acid aqueous solution, and water in total were discharged therefrom to obtain a carbosilane-siloxane copolymer solution (A). A solid content of the obtained carbosilane-siloxane copolymer solution was 22 wt%, and a weight average molecular weight (Mw) of the carbosilane-siloxane copolymer in terms of a polystyrene standard sample, which was measured by using GPC, was 4,000.

### Synthesis Example 2

1 kg of a mixed solvent obtained by mixing water and propylene glycol methyl ether acetate (PGMEA) in a weight ratio of 1:80 was put in a 3-neck flask, and then, 1 g of a 60% $HNO_3$ aqueous solution was added thereto, while maintained at 25 °C. Subsequently, a mixture of methyltrimethoxy silane (MTMS) and tetraethyl orthosilicate (TEOS) in a mole ratio of 0.75:0.30 as a monomer was added thereto. The solvent, the monomer, and a catalyst were all put together and then, heated up to 60 °C and then, heated and refluxed for 72 hours to perform a condensation polymerization reaction. A weight average molecular weight (Mw) of the obtained carbosilane-siloxane copolymer in terms of a polystyrene standard sample, which was measured by using GPC, was 3,800.

## Preparation of Composition for Forming Low Refractive Layer

### Example 1

32 wt% of the carbosilane-siloxane copolymer of Synthesis Example 1, 42 wt% of propylene glycol methyl ether acetate (PGMEA), 23 wt% of hollow particles (HS-70 (A5F); Vaxan Nano Chem), 2 wt% of a curing catalyst, and 1wt% of a surfactant F-563, which were all based on a solid content, were mixed and stirred and then, filtered with a 0.1$\mu$m-millipore filter to prepare a composition for forming a low refractive layer.

**Example 2**

A composition for forming a low refractive layer was prepared by mixing 30 wt% of the carbosilane-siloxane copolymer of Synthesis Example 1, 41 wt% of propylene glycol methyl ether acetate (PGMEA), 26 wt% of hollow particles (HS-70 (A5F); Vaxan Nano Chem), 2 wt% of a curing catalyst, and 1% of a surfactant F-563, which were all based on a solid content, and then, filtering the mixture with a 0.1$\mu$m-millipore filter.

**Example 3**

A composition for forming a low refractive layer was prepared by mixing 29 wt% of the carbosilane-siloxane copolymer of Synthesis Example 1, 39 wt% of propylene glycol methyl ether acetate (PGMEA), 29 wt% of hollow particles (HS-70 (A5F); Vaxan Nano Chem), 2 wt% of a curing catalyst, and 1% of a surfactant F-563, which were all based on a solid content and then, filtering the mixture with a 0.1$\mu$m-millipore filter.

**Comparative Example 1**

A composition for forming a low refractive layer was prepared by mixing 48 wt% of the carbosilane-siloxane copolymer of Synthesis Example 1, 47 wt% of propylene glycol methyl ether acetate (PGMEA), 4 wt% of a curing catalyst, and 1 wt% of a surfactant F-563, which were all based on a solid content, and then, filtering the mixture with a 0.1$\mu$m-millipore filter.

**Comparative Example 2**

A composition for forming the low refractive layer was prepared by mixing 7.5 wt% of the siloxane copolymer of Synthesis Example 2, 7.5 wt% of an organic polymer prepared by mixing PPO (Mn = 2,000) and cetyltrimethylammonium chloride in a weight ratio of 5:5, and 0.01% of a surfactant F-552, which were all based on a solid content, dissolving them with PGMEA for about 30 minutes, until a solid content reached 12 wt%, and then, filtering the mixture with a 0.1$\mu$m-millipore filter.

## Manufacture of Cured Film and Evaluation

The compositions according to Examples 1 to 3 and Comparative Examples 1 and 2 were respectively coated on a substrate for evaluating quantum dot efficiency with a spin coater (Opticoat MS-A150, Mikasa Co., Ltd.) at 300 rpm to 1500 rpm and then, pre-baked on a hot-plate at 100 °C for 120 seconds to form films. Subsequently, the films were cured at 230°C for 20 minutes and dried to form 1.0$\mu$m-thick coating cured films, and thicknesses of the coating cured films were measured by using Alpha-step (Surface profiler KLA, KLA-Tencor Corp.).

### (1) Refractive Index

Each coating cured film formed of the compositions for forming a low refractive layer according to Examples 1 to 3 and Comparative Examples 1 and 2 was measured with respect to a refractive index at 550 nm by using a spectroscopic ellipsometer (M-2000D, J.A.Woollam Co.), and the results are shown in Table 1.

### (2) Luminous Efficiency

Each coating cured film formed of the compositions for forming a low refractive layer according to Examples 1 to 3 and Comparative Examples 1 and 2 was measured with respect to quantum dot efficiency by using a Quantaurus-QY absolute PL quantum yield spectrometer (Modoo Technology Co., Ltd.), when applied just under a substrate for evaluating quantum dot efficiency and when applied both on and under the substrate, and the results are shown in Table 1.

(Table 1)

| | Composition (wt%) | | | Basic properties | Effect of the invention | |
|---|---|---|---|---|---|---|
| | Resin | Hollow particle | Others | Refractive index | Luminous efficiency (%) (lower portion) | Luminous efficiency (%) (upper/lower portion) |
| Example 1 | 32 | 23 | 45 | 1.23 | 120 | 150 |
| Example 2 | 30 | 26 | 44 | 1.22 | 122 | 155 |
| Example 3 | 29 | 29 | 42 | 1.21 | 122 | 162 |
| Comparative Example 1 | 48 | - | 52 | 1.32 | 100 | 101 |
| Comparative Example 2 | 7.5 | - | 92.5 | 1.39 | 95 | 98 |

Referring to Table 1, the coating cured films of Examples 1 to 3 formed of the compositions for forming the low refractive layer including hollow particles had a refractive index of less than or equal to 1.23, but the coating cured films of Comparative Examples 1 and 2 formed of the compositions for forming a low refractive layer including no hollow particles had a refractive index of greater than or equal to 1.32 and thus exhibited inferior refractive index characteristics to those of Examples 1 to 3.

In addition, when the coating cured films of Examples 1 to 3 were applied under a substrate for evaluating quantum dot efficiency, the coating cured films of Examples 1 to 3 exhibited luminous efficiency of greater than or equal to 120%, and when applied on and under the substrate, the luminous efficiency was all greater than or equal to 150%, but the coating cured films of Comparative Examples 1 and 2 exhibited luminous efficiency of less than or equal to 101%, and accordingly, the coating cured films of Examples 1 to 3 exhibited much improved luminous efficiency compared with the cured coating layers of Comparative Examples 1 and 2.

In conclusion, the coating cured films of Examples 1 to 3 exhibited improved refractive index and luminous efficiency effects compared with the coating cured films of Comparative Examples 1 and 2.

**Claims**

1. A color conversion panel (100), comprising

   a substrate (110);
   a color conversion layer (130) disposed on the substrate (110) and comprising a color conversion member;
   a low refractive layer (120) disposed between the substrate (110) and the color conversion layer (130), disposed on the color conversion layer (130), or disposed between the substrate (110) and the color conversion layer (130) and disposed on the color conversion layer (130), and
   a planarization layer (140) covering the low refractive layer (120) and the color conversion layer (130), wherein the color conversion member comprises quantum dots, and **characterized in that** the low refractive layer (120) comprises a polymer matrix and hollow particles dispersed in the polymer matrix, wherein the low refractive layer (120) has a refractive index of less than 1.32 for light having a wavelength of 500 nm to 550 nm.

2. The color conversion panel of claim 1, wherein the low refractive layer (120) is disposed on the color conversion layer (130).

3. The color conversion panel of claim 1, wherein the low refractive layer (120) has a light transmittance of greater than or equal to 90% for light having a wavelength of 400 nm.

4. The color conversion panel of claim 1, wherein the polymer matrix comprises an acrylic-based polymer and/or a silicone-based polymer and/or a silicone-based polymer formed by a hydrolysis-condensation reaction of a compound represented by Chemical Formula 1 and/or a compound represented by Chemical Formula 2:

   [Chemical Formula 1]     $(R^1)_a(R^2)_b(R^3)_c\text{-Si-}(OR^4)_{4-a-b-c}$

wherein, in Chemical Formula 1,

$R^1$ to $R^3$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, R(C=O)- (wherein, R is a substituted or unsubstituted C1 to C30 alkyl group, a substituted or unsubstituted C3 to C30 cycloalkyl group, or a substituted or unsubstituted C6 to C30 aryl group), an epoxy group, a (meth)acrylate group, a (meth)acryloyloxy group, or a combination thereof,

$R^4$ is hydrogen, or a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, or a combination thereof, and

$$0 \leq a+b+c < 4;$$

[Chemical Formula 2] $(R^7O)_{3-d-e}(R^5)_d(R^6)_e\text{-Si-}Y^1\text{-Si-}(R^B)_f(R^9)_g(O^{10})_{3-f-g}$

wherein, in Chemical Formula 2,

$R^5$, $R^6$, $R^8$, and $R^9$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, a substituted or unsubstituted C1 to C30 heteroalkyl group, a substituted or unsubstituted C2 to C30 heterocycloalkyl group, a substituted or unsubstituted C2 to C30 alkenyl group, a substituted or unsubstituted C2 to C30 alkynyl group, R(C=O)-(wherein R is a substituted or unsubstituted C1 to C30 alkyl group, a substituted or unsubstituted C3 to C30 cycloalkyl group, or a substituted or unsubstituted C6 to C30 aryl group), an epoxy group, a (meth)acrylate group, a C1 to C30 alkyl group substituted with a (meth)acrylate group, a (meth)acryloyloxy group, or a combination thereof,

$R^7$ and $R^{10}$ are independently hydrogen, a substituted or unsubstituted C1 to C30 alkyl group, a substituted or unsubstituted C3 to C30 cycloalkyl group, a substituted or unsubstituted C6 to C30 aryl group, a substituted or unsubstituted C7 to C30 arylalkyl group, or a combination thereof,

$Y^1$ is a substituted or unsubstituted C1 to C30 alkylene group, a substituted or unsubstituted C3 to C30 cycloalkylene group, a substituted or unsubstituted C6 to C30 arylene group, or a combination thereof,

$$0 \leq d+e < 3,$$

and

$$0 \leq f+g < 3.$$

5. The color conversion panel of claim 4, wherein a weight average molecular weight (Mw) of the silicone-based polymer is 1,000 to 100,000 g/mol in terms of a polystyrene standard sample.

6. The color conversion panel of claim 4, wherein the polymer matrix comprises a carbosilane-siloxane copolymer formed by a hydrolysis-condensation reaction of the compound represented by Chemical Formula 1 and the compound represented by Chemical Formula 2 and or by a hydrolysis-condensation reaction by including less than or equal to 20% of the compound represented by Chemical Formula 2, based on a total mass of the compound represented by Chemical Formula 1 and the compound represented by Chemical Formula 2.

7. The color conversion panel of claim 1, wherein the hollow particles are particulates of a hollow metal oxide including titanium oxide, silicon oxide, barium oxide, zinc oxide, zirconium oxide, or a combination thereof and/or the hollow metal oxide particulates comprise $TiO_2$, $SiO_2$, $BaTiO_3$, $Ba_2TiO_4$, $ZnO$, $ZrO_2$, or a combination thereof.

8. The color conversion panel of claim 1, wherein an average diameter ($D_{50}$) of the hollow particles is 10 nm to 150 nm.

9. The color conversion panel of claim 1, wherein a porosity of the hollow particles is 40% to 90%.

10. The color conversion panel of claim 1, wherein the hollow particles are included in an amount of less than or equal to 80 mass% based on a total mass of the low refractive layer (120).

11. The color conversion panel of claim 1, wherein the color conversion member further comprises a binder resin in which the quantum dots are dispersed.

12. The color conversion panel of claim 11, wherein the binder resin comprises an acrylic-based binder resin, a cardo-based binder resin, or a combination thereof.

13. The color conversion panel of claim 1, wherein the quantum dots have a maximum fluorescence emission at a wavelength from 500 nm to 680 nm.

14. The color conversion panel of claim 1, wherein the planarization layer (140) comprises a polymer matrix that is the same as or different from the polymer matrix included in the low refractive layer (120).

15. The color conversion panel of claim 1, wherein the color conversion panel (100) further comprises at least one of a first capping layer covering the planarization layer (140) and a second capping layer disposed between the low refractive layer (120) and the color conversion layer (130).

**Patentansprüche**

1. Farbumwandlungsplatte (100), aufweisend:

ein Substrat (110);
eine auf dem Substrat (110) angeordnete Farbumwandlungsschicht (130), die ein Farbumwandlungselement aufweist;
eine zwischen dem Substrat (110) und der Farbumwandlungsschicht (130) angeordnete Schicht (120) mit niedrigem Brechungsindex, die auf der Farbumwandlungsschicht (130) oder zwischen dem Substrat (110) und der Farbumwandlungsschicht (130) angeordnet ist und auf der Farbumwandlungsschicht (130) angeordnet ist; und
eine Planarisierungsschicht (140), die die Schicht (120) mit niedrigem Brechungsindex und die Farbumwandlungsschicht (130) bedeckt,
wobei das Farbumwandlungselement Quantenpunkte aufweist,
**dadurch gekennzeichnet, dass**
die Schicht (120) mit niedrigem Brechungsindex eine Polymermatrix und hohle Partikel aufweist, die in der Polymermatrix dispergiert sind,
wobei die Schicht mit niedrigem Brechungsindex (120) einen Brechungsindex von weniger als 1,32 für Licht mit einer Wellenlänge von 500 nm bis 550 nm aufweist.

2. Farbumwandlungsplatte nach Anspruch 1, wobei die Schicht mit niedrigem Brechungsindex (120) auf der Farbumwandlungsschicht (130) angeordnet ist.

3. Farbumwandlungsplatte nach Anspruch 1, wobei die Schicht mit niedrigem Brechungsindex (120) eine Lichtdurchlässigkeit von größer oder gleich 90% für Licht mit einer Wellenlänge von 400 nm aufweist.

4. Farbumwandlungsplatte nach Anspruch 1, wobei die Polymermatrix ein Polymer auf Acrylbasis und/oder ein Polymer auf Silikonbasis und/oder ein Polymer auf Silikonbasis aufweist, das durch eine Hydrolysekondensationsreaktion einer durch die chemische Formel 1 dargestellten Verbindung und/oder einer durch die chemische Formel 2 dargestellten Verbindung gebildet wird:

[chemische Formel 1] $(R^1)_a(R^2)_b(R^3)_c\text{-Si-}(OR^4)_{4-a-b-c}$,

wobei in der chemischen Formel 1

$R^1$ bis $R^3$ unabhängig voneinander Wasserstoff, eine substituierte oder unsubstituierte C1- bis C30-Alkylgruppe, eine substituierte oder unsubstituierte C3- bis C30-Cycloalkylgruppe, eine substituierte oder unsubstituierte C6- bis C30-Arylgruppe, eine substituierte oder unsubstituierte C7- bis C30-Arylalkylgruppe, eine substituierte oder unsubstituierte C1- bis C30-He-teroalkylgruppe, eine substituierte oder unsubstituierte C2- bis C30-Heterocycloalkylgruppe, eine substituierte oder unsubstituierte C2- bis C30-Alkenylgruppe, eine substituierte oder unsubstituierte C2- bis C30-Alkinylgruppe, $R(C=O)-$ (wobei R eine substituierte oder unsubstituierte C1-C30-Alkylgruppe, eine substituierte oder unsubstituierte C3- bis C30-Cycloalkylgruppe oder eine substituierte oder unsubstituierte C6- bis C30-Arylgruppe ist), eine Epoxygruppe, eine (Meth)acrylatgruppe, eine (Meth)acryloyloxygruppe oder eine Kombination davon sind,

$R^4$ Wasserstoff oder eine substituierte oder unsubstituierte C1- bis C30-Alkylgruppe, eine substituierte oder unsubstituierte C3- bis C30-Cycloalkylgruppe, eine substituierte oder unsubstituierte C6- bis C30-Arylgruppe, eine substituierte oder unsubstituierte C7- bis C30-Arylalkylgruppe oder eine Kombination davon ist, und

$$0 \leq a+b+c < 4 \text{ ist,}$$

[chemische Formel 2]     $(R^7O)_{3-d-e}(R^5)_d(R^6)_e\text{-Si-}Y^1\text{-Si-}(R^8)_f(R^9)_g(OR^{10})_{3-f-g}$

wobei in der chemischen Formel 2

$R^5$, $R^6$, $R^8$ und $R^9$ unabhängig voneinander Wasserstoff, eine substituierte oder unsubstituierte C1- bis C30-Alkylgruppe, eine substituierte oder unsubstituierte C3- bis C30-Cycloalkylgruppe, eine substituierte oder unsubstituierte C6- bis C30-Arylgruppe, eine substituierte oder unsubstituierte C7-bis C30-Arylalkylgruppe, eine substituierte oder unsubstituierte C1- bis C30-Heteroalkylgruppe, eine substituierte oder unsubstituierte C2- bis C30-Hete-rocycloalkylgruppe, eine substituierte oder unsubstituierte C2- bis C30-Alkenylgruppe, eine substituierte oder unsubstituierte C2- bis C30-Alkinylgruppe, $R(C=O)-$ (wobei R eine substituierte oder unsubstituierte C1- bis C30-Alkylgruppe, eine substituierte oder unsubstituierte C3- bis C30-Cycloalkylgruppe oder eine substituierte oder unsubstituierte C6- bis C30-Arylgruppe ist), eine Epoxygruppe, eine (Meth)acrylatgruppe, eine mit einer (Meth)acrylatgruppe substituierte C1- bis C30-Alkylgruppe, eine (Meth)acryloyloxygruppe oder eine Kombination davon sind,

$R^7$ und $R^{10}$ unabhängig voneinander Wasserstoff, eine substituierte oder unsubstituierte C1- bis C30-Alkylgruppe, eine substituierte oder unsubstituierte C3- bis C30-Cycloalkylgruppe, eine substituierte oder unsubstituierte C6- bis C30-Arylgruppe, eine substituierte oder unsubstituierte C7- bis C30-Arylalkylgruppe oder eine Kombination davon sind,

$Y^1$ eine substituierte oder unsubstituierte C1- bis C30-Alkylengruppe, eine substituierte oder unsubstituierte C3- bis C30-Cycloalkylengruppe, eine substituierte oder unsubstituierte C6- bis C30-Arylengruppe oder eine Kombination davon ist,

$$0 \leq d+e < 3,$$

und

$$0 \leq f+g < 3 \text{ ist.}$$

5. Farbumwandlungsplatte nach Anspruch 4, wobei das gewichtsmittlere Molekulargewicht (Mw) des Polymers auf Silikonbasis 1000 bis 100000 g/mol, bezogen auf eine Polystyrol-Standardprobe, beträgt.

6. Farbumwandlungsplatte nach Anspruch 4, wobei die Polymermatrix ein Carbosilan-Siloxan-Copolymer aufweist, das durch eine Hydrolysekondensationsreaktion der Verbindung der chemischen Formel 1 und der Verbindung der chemischen Formel 2 und/oder durch eine Hydrolysekondensationsreaktion unter Einbeziehung von weniger als oder gleich 20% der Verbindung der chemischen Formel 2 gebildet wird, bezogen auf die Gesamtmasse der durch die chemische Formel 1 dargestellten Verbindung und der durch die chemische Formel 2 dargestellten Verbindung.

7. Farbumwandlungsplatte nach Anspruch 1, wobei die hohlen Partikel Partikel eines hohlen Metalloxids sind, das Titanoxid, Siliziumoxid, Bariumoxid, Zinkoxid, Zirkoniumoxid oder eine Kombination davon aufweist, und/oder die hohlen Metalloxidpartikel $TiO_2$, $SiO_2$, $BaTiO_3$, $Ba_2TiO_4$, ZnO, $ZrO_2$ oder eine Kombination davon aufweisen.

**8.** Farbumwandlungsplatte nach Anspruch 1, wobei der durchschnittliche Durchmesser ($D_{50}$) der hohlen Partikel 10 nm bis 150 nm beträgt.

**9.** Farbumwandlungsplatte nach Anspruch 1, wobei die Porosität der hohlen Partikel 40% bis 90% beträgt.

**10.** Farbumwandlungsplatte nach Anspruch 1, wobei die hohlen Partikel in einer Menge von weniger als oder gleich 80 Masse-%, bezogen auf die Gesamtmasse der Schicht mit niedrigem Brechungsindex (120), enthalten sind.

**11.** Farbumwandlungsplatte nach Anspruch 1, wobei das Farbumwandlungselement ferner ein Bindemittelharz aufweist, in dem die Quantenpunkte dispergiert sind.

**12.** Farbumwandlungsplatte nach Anspruch 1, wobei das Bindemittelharz ein Bindemittelharz auf Acrylbasis, ein Bindemittelharz auf Cardobasis oder eine Kombination davon aufweist.

**13.** Farbumwandlungsplatte nach Anspruch 1, wobei die Quantenpunkte eine maximale Fluoreszenzemission bei einer Wellenlänge von 500 nm bis 680 nm aufweisen.

**14.** Farbumwandlungsplatte nach Anspruch 1, wobei die Planarisierungsschicht (140) eine Polymermatrix aufweist, die mit der in der Schicht mit niedrigem Brechungsindex (120) enthaltenen Polymermatrix identisch oder davon verschieden ist.

**15.** Farbumwandlungsplatte nach Anspruch 1, wobei die Farbumwandlungsplatte (100) ferner mindestens eine die Planarisierungsschicht (140) bedeckende erste Deckschicht und eine zwischen der Schicht mit niedrigem Brechungsindex (120) und der Farbumwandlungsschicht (130) angeordnete zweite Deckschicht aufweist.

**Revendications**

**1.** Panneau de conversion de couleur (100), comprenant

un substrat (110) ;
une couche de conversion de couleur (130) disposée sur le substrat (110) et comprenant un élément de conversion de couleur ;
une couche à faible indice de réfraction (120) disposée entre le substrat (110) et la couche de conversion de couleur (130), disposée sur la couche de conversion de couleur (130), ou disposée entre le substrat (110) et la couche de conversion de couleur (130) et disposée sur la couche de conversion de couleur, et
une couche de planarisation (140) couvrant la couche à faible indice de réfraction (120) et la couche de conversion de couleur (130),
dans lequel l'élément de conversion de couleur comprend des points quantiques, et **caractérisé en ce que**
la couche à faible indice de réfraction (120) comprend une matrice polymère et des particules creuses dispersées dans la matrice polymère,
dans lequel la couche à faible indice de réfraction (120) a un indice de réfraction de moins de 1,32 pour de la lumière ayant une longueur d'onde de 500 nm à 550 nm.

**2.** Panneau de conversion de couleur selon la revendication 1, dans lequel la couche à faible indice de réfraction (120) est disposée sur la couche de conversion de couleur (130).

**3.** Panneau de conversion de couleur selon la revendication 1, dans lequel la couche à faible indice de réfraction (120) a une transmission lumineuse supérieure ou égale à 90% pour de la lumière ayant une longueur d'onde de 400 nm.

**4.** Panneau de conversion de couleur selon la revendication 1, dans lequel la matrice polymère comprend un polymère à base acrylique et/ou un polymère à base de silicone et/ou un polymère à base de silicone formé par une réaction d'hydrolyse-condensation d'un composé représenté par la Formule Chimique 1 et/ou un composé représenté par la Formule Chimique 2 :

[Formule Chimique 1]
$(R^1)_a(R^2)_b(R^3)_c\text{-Si-}(OR^4)_{4-a-b-c}$
dans lequel, dans la Formule Chimique 1,

R$^1$ à R$^3$ sont indépendamment un hydrogène, un groupement alkyle en C1 à C30 substitué ou non substitué, un groupement cycloalkyle en C3 à C30 substitué ou non substitué, un groupement aryle en C6 à C30 substitué ou non substitué, un groupement arylalkyle en C7 à C30 substitué ou non substitué, un groupement hétéroalkyle en C1 à C30 substitué ou non substitué, un groupement hétérocycloalkyle en C2 à C30 substitué ou non substitué, un groupement alcényle en C2 à C30 substitué ou non substitué, un groupement alcynyle en C2 à C30 substitué ou non substitué, R(C=O)- (dans lequel, R est un groupement alkyle en C1 à C30 substitué ou non substitué, un groupement cycloalkyle en C3 à C30 substitué ou non substitué, un groupement aryle en C6 à C30 substitué ou non substitué), un groupement époxy, un groupement méthacrylate, un groupement méthacryloyloxy, ou une combinaison de ceux-ci,

R$^4$ est un hydrogène, ou un groupement alkyle en C1 à C30 substitué ou non substitué, un groupement cycloalkyle en C3 à C30 substitué ou non substitué, un groupement aryle en C6 à C30 substitué ou non substitué, un groupement arylalkyle en C7 à C30 substitué ou non substitué, ou une combinaison de ceux-ci, et

$$0 \leq a+b+c \leq 4 \;;$$

[Formule Chimique 2] $\quad (R^7O)_{3-d-e}(R^5)d(R^6)_e\text{-Si-Y}^1\text{-Si}(R^8)_f(R^9)_g(OR^{10})_{3-f-g}$

dans lequel, dans la Formule Chimique 2,

R$^5$, R$^6$, R$^8$, et R$^9$ sont indépendamment un hydrogène, un groupement alkyle en C1 à C30 substitué ou non substitué, un groupement cycloalkyle en C3 à C30 substitué ou non substitué, un groupement aryle en C6 à C30 substitué ou non substitué, un groupement arylalkyle en C7 à C30 substitué ou non substitué, un groupement hétéroalkyle en C1 à C30 substitué ou non substitué, un groupement hétérocycloalkyle en C2 à C30 substitué ou non substitué, un groupement alcényle en C2 à C30 substitué ou non substitué, un groupement alcynyle en C2 à C30 substitué ou non substitué, R(C=O)- (dans lequel, R est un groupement alkyle en C1 à C30 substitué ou non substitué, un groupement cycloalkyle en C3 à C30 substitué ou non substitué, un groupement aryle en C6 à C30 substitué ou non substitué), un groupement époxy, un groupement méthacrylate, un groupement alkyle en C1 à C30 substitué avec un groupement méthacrylate, un groupement méthacryloyloxy, ou une combinaison de ceux-ci,

R$^7$ et R$^{10}$ sont indépendamment un hydrogène, un groupement alkyle en C1 à C30 substitué ou non substitué, un groupement cycloalkyle en C3 à C30 substitué ou non substitué, un groupement aryle en C6 à C30 substitué ou non substitué, un groupement arylalkyle en C7 à C30 substitué ou non substitué, ou une combinaison de ceux-ci,

Y$^1$ est un groupement alkylène en C1 à C30 substitué ou non substitué, un groupement cycloalkylène en C3 à C30 substitué ou non substitué, un groupement arylène en C6 à C30 substitué ou non substitué, ou une combinaison de ceux-ci,

$$0 \leq d+e < 3,$$

et

$$0 \leq f+g < 3.$$

**5.** Panneau de conversion de couleur selon la revendication 4, dans lequel une masse molaire moyenne en poids (Mw) du polymère à base de silicone est 1000 à 100000 g/mol par rapport à un échantillon étalon de polystyrène.

**6.** Panneau de conversion de couleur selon la revendication 4, dans lequel la matrice polymère comprend un copolymère carbosilane-siloxane formé par une réaction d'hydrolysecondensation du composé représenté par la Formule Chimique 1 et le composé représenté par la Formule Chimique 2 et/ou par une réaction d'hydrolyse-condensation en incluant 20% ou moins du composé représenté par la Formule Chimique 2, sur la base d'une masse totale du composé représenté par la Formule Chimique 1 et du composé représenté par la Formule Chimique 2.

**7.** Panneau de conversion de couleur selon la revendication 1, dans lequel les particules creuses sont des particules d'oxyde métallique creux incluant de l'oxyde de titane, oxyde de silicium, oxyde de baryum, oxyde de zinc, oxyde de zirconium, ou une combinaison de ceux-ci et/ou les particules d'oxyde métallique creux comprennent $TiO_2$, $SiO_2$, $BaTiO_3$, $Ba_2TiO_4$, ZnO, $ZrO_2$, ou une combinaison de ceux-ci.

8. Panneau de conversion de couleur selon la revendication 1, dans lequel un diamètre moyen ($D_{50}$) des particules creuses est de 10 nm à 150 nm.

9. Panneau de conversion de couleur selon la revendication 1, dans lequel une porosité des particules creuses est de 40% à 90%.

10. Panneau de conversion de couleur selon la revendication 1, dans lequel les particules creuses sont inclues dans une quantité inférieure ou égale à 80 % en poids par rapport à une masse totale de la couche à faible indice de réfraction (120).

11. Panneau de conversion de couleur selon la revendication 1, dans lequel l'élément de conversion de couleur comprend en outre une résine de liant dans laquelle les points quantiques sont dispersés.

12. Panneau de conversion de couleur selon la revendication 11, dans lequel la résine de liant comprend une résine de liant à base acrylique, une résine de liant à base de cardo, ou une combinaison de celles-ci.

13. Panneau de conversion de couleur selon la revendication 1, dans lequel les points quantiques ont une émission de fluorescence maximale à une longueur d'onde de 500 nm à 680 nm.

14. Panneau de conversion de couleur selon la revendication 1, dans lequel la couche de planarisation (140) comprend une matrice polymère qui est identique ou différente de la matrice polymère incluse dans la couche à faible indice de réfraction (120).

15. Panneau de conversion de couleur selon la revendication 1, dans lequel le panneau de conversion de couleur (100) comprend en outre au moins un d'une première couche de couverture couvrant la couche de planarisation (140) et une deuxième couche de couverture disposée entre la couche à faible indice de réfraction (120) et la couche de conversion de couleur (130).

【FIG. 1】

【FIG. 2】

【FIG.3】

【FIG. 4】

【FIG. 5】

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020190068226
- EP 3451052 A
- EP 2180354 A
- EP 3447572 A